Europäisches Patentamt

European Patent Office

Office européen des brevets

(11) Publication number: **0 083 240**
**B1**

# (12) EUROPEAN PATENT SPECIFICATION

(45) Date of publication of patent specification: **01.06.88**

(51) Int. Cl.⁴: **H 01 L 27/14,** H 04 N 3/15

(21) Application number: **82306971.1**

(22) Date of filing: **24.12.82**

(54) Solid state image sensor with high resolution.

(30) Priority: 25.12.81 JP 209381/81
15.03.82 JP 39429/82
12.05.82 JP 78328/82
12.05.82 JP 78331/82

(43) Date of publication of application:
06.07.83 Bulletin 83/27

(45) Publication of the grant of the patent:
01.06.88 Bulletin 88/22

(84) Designated Contracting States:
DE FR GB NL

(56) References cited:
EP-A-0 065 885
EP-A-0 067 043
FR-A-2 486 387

IEEE TRANSACTIONS ON ELECTRON
DEVICES, vol. ED-20, no. 6, June 1973, pages
535-541, New York, US C.H. SEQUIN:
"Interlacing in charge-coupled imaging
devices"

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Harada, Nozomu**
**805-8, Higashihongo-cho**
**Midori-ku Yokohama-shi (JP)**
Inventor: **Yoshida, Okio**
**2-24-501, Sakonyama-danchi**
**Asahi-ku Yokohama-shi (JP)**
Inventor: **Tanuma, Chiaki**
**3-8-15, Nishikamata**
**Oota-ku Tokyo (JP)**
Inventor: **Yokoyama, Katsunori**
**5-1-14, Kokubunjidai**
**Ebina-shi Kanagawa-ken (JP)**
Inventor: **Suda, Yoshiyuki**
**C-403, Toshiba-Kikuna-ryo 217 Mamedo-cho**
**Kohoku-ku Yokohama-shi (JP)**

(74) Representative: **Freed, Arthur Woolf et al**
**MARKS & CLERK 57-60 Lincoln's Inn Fields**
**London WC2A 3LS (GB)**

### Description

The present invention relates to solid state image sensors, and more particularly to solid state image sensors for reproducing high definition images.

Charge transfer devices (CTD) such as charge coupled devices have been known as solid state image sensors adaptable for standard television system, for example, National Television Systems Committee (NTSC) system and have found a variety of applications. In NTSC system, the number of vertical scanning lines is 512, the scanning system is of an interlacing scanning type with two fields for one frame, and the aspect ratio is 3:4. The number of picture elements of a CCD adaptable for the standard TV system, for example, in interline transfer type CCD (IT-CCD) is approximately 500 (vertical)×400 (horizontal).

The solid state image sensor such as the IT-CCD is superior to the conventional image pick-up tube in many points. For example, the image sensor is small in size, light in weight, and high in reliability. Further, it is essentially free from the pattern distortion and sticking, and is little influenced by afterimage sensor with such excellent features has a prospect of increasing applications in many fields, for example, ITV, small commercial video cameras which will supercede the conventional cameras using silver salt-film. For applying the image sensor for such fields, a remarkable resolution improvement of the reproduced picture is required for the solid state image sensor in order to ensure a high quality of picture.

High definition wide television system, which can provide wide and high definition pictures are prospective television systems as the next generation television. The study of the high definition wide television system reports that the scanning lines must be 1,000 or more, for example, 1,125. To satisfy such requirement, the improvement of the resolution of the solid state image sensor is very of significance.

The number of picture elements 500×400 of the currently used solid state image sensor, for example, IT-CCD, is too small to realize the high resolution. Therefore, it is considered that the number of picture elements must be remarkably increased. It is to be noted that the solid state image sensor currently used needs one of the largest chip sizes of LSIs. Therefore, if the number of picture elements is simply increased for the above purposes, the chip size of the image sensor is considerably increased. This leads to increase of the size and cost of the image sensor. On the other hand, if the number of picture elements is increased while keeping the present chip size of the image sensor, the integration density of the chip must considerably be improved, for example, four times or more. The LSI chips with such a high integration density, however, involves a difficulty in fabricating them by the fabricating technology at the present stage. Even if in the future, the fabricating technology advances and realizes the solid stage image sensors with a high integration density, a new problem arises that a drive system for such image sensors must be complicated and consume large power.

EP—A—65—885 (prior art by virtue of A54(3) only), discloses a photosensitive spatially-periodic charge transfer matrix which comprises equidistant rows and columns defining elementary pixel modules. Signals corresponding to points of an optical image are processed in an interlaced line-scan mode as the matrix is displaced through half the width of a line and restored to its initial position. The displacement is effected by a moving coil in the radial field of an electromagnet energized by square waves at the repetition frequency of the picture scan. The resilient frequency of the system is defined by springs.

An object of the present invention is to provide a new and improved solid state image sensor with a high resolution.

Another object of the present invention is to provide a new and improved solid state image sensor having a resolution comparable with that of the solid site image sensor which has successfully increased hhe number of picture elements without increasing the chip size of the integration density of picture elements.

According to the present invention there is provided a device for sensing an incident light image comprising a solid state image sensing device which senses a light image compatible with a predetermined television system in which one frame includes a plurality of fields including first and second fields, said image sensing device comprising sensing means for receiving radiation representing image information and for generating and storing charges corresponding to the radiation, said sensing means including at least one linear cell array containing a predetermined number of cells, and transfer means disposed adjacent to said sensing means for reading out and transferring the charges stored in said sensing means, said transfer means including at least one linear transfer section extending along said linear cell array, and wherein a displacement generating means is mechanically coupled to said image sensing device, for swinging said image sensing device in such a manner that the image sensing device relatively moves in a plane substantially orthogonal to the direction of the incident radiation and each cell is located at different sensing positions during different field periods in one frame period of the television system, whereby signal charges collected during the first field period are simultaneously read out from said cell array to said transfer section before said each cell is located at the following position for storing signal charges corresponding to an image of the second field, so that the image resolution of the frame image is improved.

The described embodiments of thepuolid state image sensor are provided with a solid state image sensing device such as a charge transfer device. The image sensing device includes a

sensing section which receives incident radiation representing image information, generates and stores charges corresponding to the radiation, and at least one transfer section. The sensing section is provided with at least one train of cells including a predetermined number of cells. The transfer section is disposed adjacent to and extends along the cell train. The transfer section reads out and transfers the charges stored in the sensing section. The image sensor is further provided with a device for generating a vibration to provide a position reciprocal replacement of the cell train between the incident radiation and the image sensing device at given time periods. The vibration of the cell train is done for sensing the light image at different positions with respect to the incident radiation at differnt time points. With this arrangement, an effective image sensing area of the image sensing device is increased. Consequently, the resolution of the reproduced picture may be improved without increasing the integration density of the cell train. Thus, fine and definite reproduced picture may be obtained.

Embodiments of the present invention will now be described, by way of example, with reference to the accompanying drawings, in which:

Fig. 1 is a block diagram showing an overall arrangement of a solid state image sensor according to one embodiment of the present invention;

Fig. 2 is a plan view of an image sensing area of an interline transfer charge coupled device (IT-CCD) of Fig. 1;

Fig. 3 is a partial plan view of an area in the image sensing area of Fig. 2, which corresponds to one picture element;

Fig. 4A illustrates a model of a vibration or swing of one picture element area in Fig. 3 for illustrating an IT-CCD swing mode in Fig. 1;

Fig. 4B shows a waveform of vibration of IT-CCD illustrated corresponding to one picture element area in Fig. 3A;

Fig. 5A is a waveform of an electrical signal supplied to a field shift gate (FSG) of IT-CCD in Fig. 1 during a period of one frame;

Fig. 5B shows a waveform of swing of the IT-CCD illustrated corresponding to the signal waveform of Fig. 5A;

Fig. 6A illustrates a model of swing of a part of the image sensing area for explaining another swing mode of the IT-CCD of Fig. 1;

Fig. 6B is a waveform of another swing mode of the IT-CCD illustrated corresponding to the partial image sensing area of Fig. 6A;

Fig. 7A illustrates a waveform of swing illustrating yet another swing mode of the IT-CCD;

Fig. 7B illustrates an effective photosensing distribution of the IT-CCD vibrating in the swing mode of Fig. 7A;

Fig. 7C shows an effective photosensing distribution of the IT-CCD vibrating in a trapezoidal wave swing mode shown in Figs. 4B and 6B;

Fig. 8 shows a waveform illustrating a sinusoidal swing mode as a modification of the triangle swing mode of Fig. 7A;

Fig. 9A illustrates a model of one cell area illustrating a swing mode adaptable for an image sensing or pick-up system in which one frame is composed of four fields;

Figs. 9B and 9C show graphs illustrating X- and Y-axial displacements of the IT-CCD swinging in the swing mode of Fig. 9A with respect to time;

Fig. 9D illustrates a waveform of an electrical signal supplied on an FSG in the IT-CCD swinging in the swing mode of Fig. 9A;

Fig. 10A shows a model of a modification of a swing mode shown in Fig. 9A;

Figs. 10B and 10C are graphs illustrating X- and Y-axial displacements of the IT-CCD swinging in the swing mode of Fig. 10A;

Fig. 10D shows a graph illustrating a swing waveform in a swing mode adaptable for an image sensing system of the type in which one frame is composed of eight fields;

Fig. 11A is a model illustrating another modification of the swing mode shown in Fig. 9A;

Figs. 11B and 11C show graphs illustrating X- and Y-axial displacements of the IT-CCD swinging in the swing mode shown in Fig. 11A;

Fig. 12 shows an arrangement of an IT-CCD which corresponds to the Fig. 2 IT-CCD of which the planer surface of the image sensing area is modified, with the vertical CCD having the same number of transfer stages as that of the number of picture elements of the cell line adjacent to the vertical CCD;

Fig. 13 shows a partial plan view of the image sensing area of the IT-CCD for illustrating a displacement of a cell matrix of IT-CCD when the Fig. 12 IT-CCD is horizontally vibrated;

Fig. 14 shows a partial plan view of the image sensing area of the IT-CCD for illustrating a displacement of the cell array for vibrating the Fig. 12 IT-CCD in a slanted direction;

Fig. 15A is a partial plan view showing the practical structure of the IT-CCD of Fig. 12;

Fig. 15B shows an enlarged plan view of a part of the IT-CCD for definitely illustrating electrode layers overlaid with respect to each other in Fig. 15A;

Fig. 16 shows a partial cross sectional view taken on line XVI—XVI;

Fig. 17 shows a partial cross sectional view illustrating a cross sectional view taken on line XVII—XVII in Fig. 15A;

Fig. 18A is a perspective view of an image sensor deflection device for vibrating or swinging the Fig. 12 IT-CCD in the vibration mode of Fig. 13;

Fig. 18B shows a perspective view of a structure of a plate type bimorph vibrating element fixed sandwiching the film connector of Fig. 18A;

Fig. 19A shows a perspective view of a modification of the image sensor deflection device of Fig. 18A;

Fig. 19B shows a perspective view of an arrangement of one of the bimorph piezoelectric elements used in the image sensor deflection device of Fig. 19A;

Fig. 20 shows a perspective view of another modification of the image sensor deflection device of Fig. 18A;

Fig. 21 shows a displacement characteristic of a bimorph piezoelectric element of the image sensor deflection device of Fig. 20.

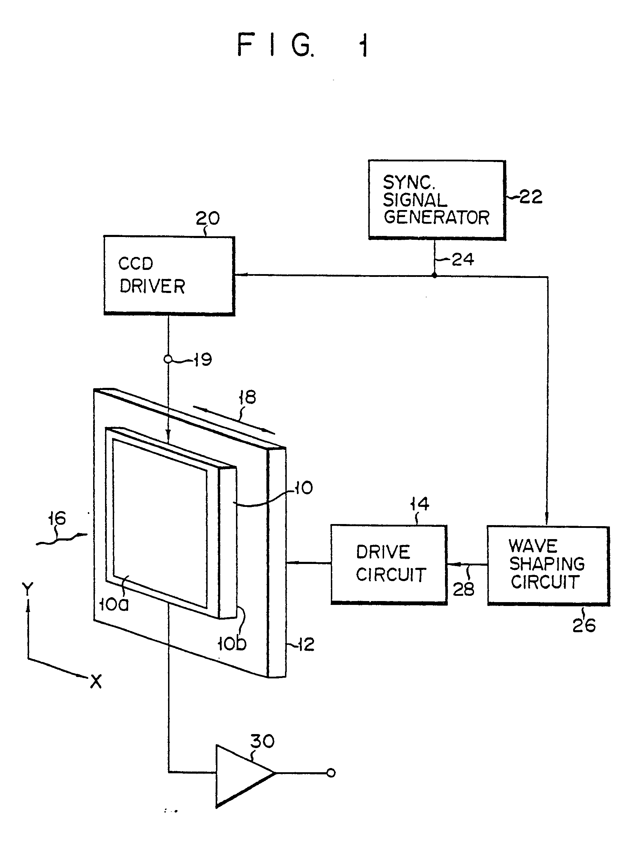

Referring now to Fig. 1, there is schematically shown a solid state image sensor arrangement according to an embodiment of the present invention. The image sensor arrangement is so designed that a solid state image sensor per se vibrates or swings for incident light image. In Fig. 1, a solid stave image sensor, for example, an interline transfer charge coupled device (IT-CCD) 10 has an ordinary number of picture elements, for example, $500 \times 400$. The IT-CCD is fixed to a vibrating table 12, at the rear side 10b opposite to the image sensing area 10a. The vibrating table 12 vibrates or swings in a plane normal to the incident image rays 16, in a given direction, for example, a horizontal direction as indicated by an arrow 18. Accordingly, the IT-CCD 10 fixed to the vibrating table 12 vibrates or swings in the vibrating mode, too.

The IT-CCD 10 is electrically connected through a gate terminal 19 to a CCD driver 20. The CCD driver 20 responds to a sync pulse signal 24 generated by a sync signal generating circuit 22, thereby to drive the IT-CCD 10. The sync signal generating circuit 22 is also electrically connected to a wave shaping circuit 26 connected to the drive circuit 14. The wave shaping circuit 26 receives the sync pulse signal 24 from the sync signal generating circuit 22 and wave-shapes the sync pulse signal 24 to produce a sync pulse signal 28 necessary for vibrating the vibrating table 12. The wave-shaped sync pulse signal 28 is supplied to the drive circuit 14 for vibrating the table 12. The output terminal of the vibrating or swinging IT-CCD 10 is connected to a video signal amplifier 30.

The IT-CCD 10 is provided with a photosensitive portion 32 made up of photosensitive elements, for example, photodiodes $P_{11}$, $P_{11}'$, $P_{12}$, $P_{12}'$,..., $P_{1N}$, $P_{1N}'$,..., $P_{ij}$, $P_{ij}'$,..., $P_{MN}$, $P_{MN}'$. Of photodiodes P vertically arranged, the adjacent photodiodes are paired and designated by paired notation, as just above. This is done for making the notation of the photodiodes arrayed comply with the conventional one adaptable for NTSC system. These photodiodes P are arrayed on a CCD substrate (not shown) in a matrix fashion. In the matrix array each column includes photodiodes of 2N and the columns of M are arrayed side by side. M vertical CCDs $C_1$ to $C_M$ are disposed adjacent to the M photodiodes columns, respectively. The number of vertical CCDs $C_1$ to $C_M$ is equal to the number of vertical picture elements in the IT-CCD 10, that is, the half (N) of the number of photodiodes contained in each photodiode column. The vertical CCDs $C_1$ to $C_M$ are connected at their final transfer stage to a horizontal CCD shift register S. A field shift gate (FSG) 34 is arranged with the gate portions each extending through gaps between the vertical photodiode columns $P_1$ to $P_M$ and the vertical CCDs $C_1$ to $C_M$. The FSG 34 is electrically connected to the gate terminal 19. When a pulse signal (a gate control signal) is applied from the CCD driver 20 to the FSG 34 through the gate terminal 19, the signal charge stored in the photodiodes P is transferred to the vertical CCDs $C_1$ to $C_M$. The signal charge transferred to the vertical CCDs $C_1$ to $C_M$ is sequentially transferred to the horizontal CCD shift register S for each stage. The charge is then read out from the output terminal 36 through the amplifier 30.

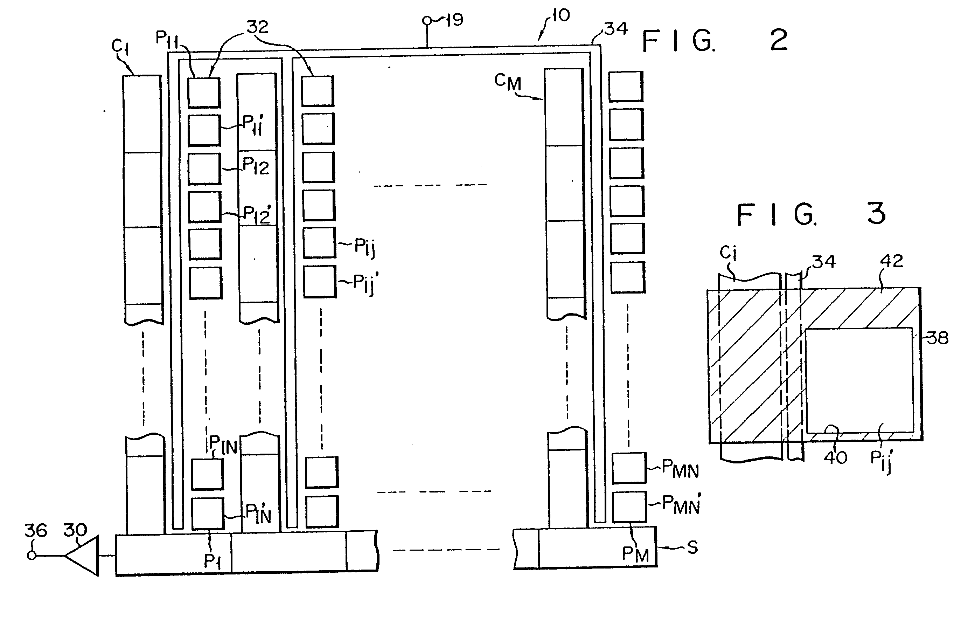

Fig. 3 shows an enlarged plan view of an image sensing area corresponding to one picture element or one cell in the photosensitive portion 32 of the IT-CCD 10 in Fig. 2. A hatched portion 38 indicates an aluminum electrode serving to shut off the incident light. The Al electrode 38 has an opening 40 under which the photodiode $P_{ij}'$ is located. The vertical CCD $C_i$ and the FSG 34 run under the Al electrode 38, and hence are optically shielded from light rays by the Al electrode 38. An internal interconnection pattern (not shown) for driving the vertical CCD $C_i$ is formed under an area 42 of the Al electrode 38 located above the photodiode $P_{ij}$. The area 42 of the Al electrode 38 performs optical isolation between the photodiodes $P_{ij}$ and $P_{ij}'$.

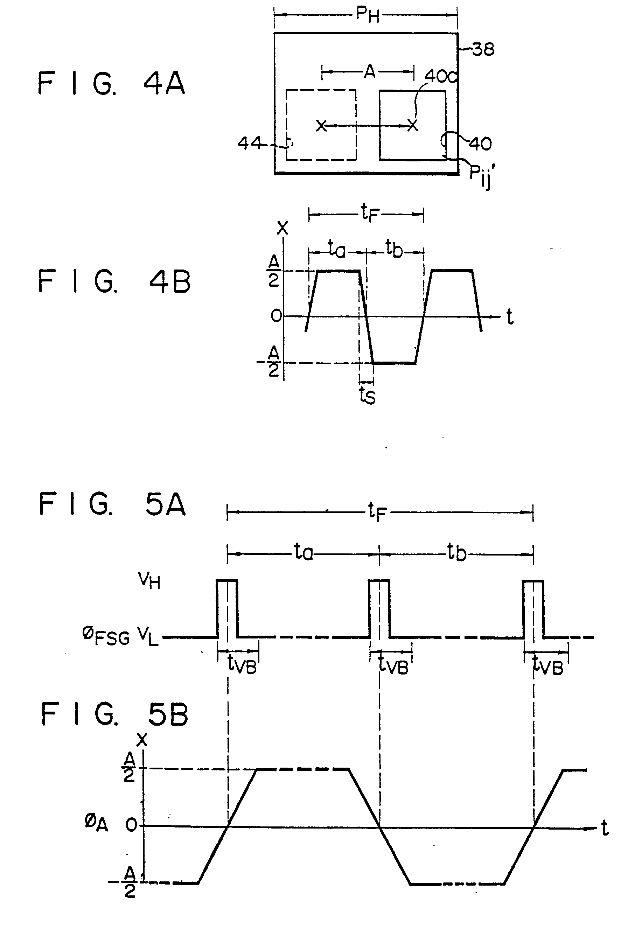

The present embodiment is applied for the image sensing based on NTSC television system. Accordingly, the IT-CCD 10 is vibrated or swinged horizontally in Fig. 1, i.e. in the horizontal direction, at a period corresponding to one frame period $t_F$ (two fields period) in the image sensing operation. The vibration mode (or swing mode) of the IT-CCD 10 will now be described referring to Figs. 4 and 5.

Fig. 4A illustrates again the one cell area shown in Fig. 3 in a model, for explaining the swing mode of the IT-CCD 10. The IT-CCD 10 is swinged, according to a vibration waveform as shown in Fig. 4B, so that during a field A in one frame period $t_F$, the opening 40 where the one cell $P_{ij}'$ of the IT-CCD 10 is located at a first location as indicated by a solid line in Fig. 4A, on the other hand, during a field B, it is positioned at a second location denoted by a dotted line 44. The swing width of the CCD is denoted as A. If the center of the swing in this coordinates system is 0, the CCD reciprocately swings a A/2 distance positively and negatively with respect to the center 0. If the period $t_S$ (Fig. 4B) that the center 40c of the opening 40 of the Al electrode 38 moves from $X = A/2$ to $-X = A/2$ is sufficiently shorter than the one frame period $t_F$, the opening center 40c, i.e. the center of the cell $P_{ij}'$, rests at $X = A/2$ during the field A period $t_a$. During the field B period $t_b$, it rests at $X = -A/2$. Since the amplitude A is set much smaller than the horizontal pitch length $P_H$, the cell has substantially two different spatial sampling areas in the horizontal direction during the one frame period $t_F$. While one cell $P_{ij}$ have typically been described, the same thing is true for the remaining cells.

In Fig. 5, there are shown a voltage signal waveform $\phi FSG$ from the photosensitive portion to the FSG 34 for controlling the transfer of the signal charge to the vertical CCDs $C_1$ to $C_M$, and a time variation $\phi A$ of the opening center 40c. As shown in Fig. 5A, the voltage signal from the CCD driver 20 in a pulse signal changing between a low level potential $V_L$ and a high level potential $V_H$. During the vertical blanking period $t_{VB}$ of the IT-CCD 10, the pulse component at high level potential $V_H$ is applied to the FSG 34 (Fig. 2). The signal charge stored in the photosensitive section 32 by image-sensing the incident image light rays is transferred through the FSG 34 to the vertical CCDs $C_1$ to $C_M$. The time variation waveform $\phi_A$ of position of the cell center 40c shown in Fig. 5B is so arranged as to cross the coordinate X=0 during the vertical blanking period $t_{VB}$ and within a period that the pulse signal from the CCD driver 20 shown in Fig. 5A is at $V_H$. Accordingly, the signal charge stored in the photosensitive section 32 during the field A period $t_a$ corresponds to the image light incident on the IT-CCD 10 when the IT-CCD 10 is positioned at X=A/2. The signal charge obtained during the field B period $t_b$ corresponds to the image light incident on the IT-CCD 10 when the IT-CCD 10 is at X=−A/2.

The IT-CCD 10 thus arranged unlike the conventional IT-CCD picking up an image at the same position through the periods of fields A and B, may pick up an image from the incident image light at different positions during the periods of fields A and B. In reproducing the image thus formed, if the read out cell signals or the image picture signals of the fields A and B thus obtained are visualized spacially shifted in horizontal direction so as to be adapted for the aforementioned CCD sampling operation, the resolution of the reproduced picture can be improved essentially two times. In the present embodiment, the cell center 40c merely reciprocates in horizontal direction every field period. The horizontal reciprocal movement of the IT-CCD 10 has little adverse influence on the vertical resolution of the reproduced picture.

As described above, the present embodiment employs a solid state image sensor such as IT-CCD arranged such that the signal charges stored in the photosensitive section are simultaneously read out and transferred to the vertical CCD sections for each field and during the blanking period. The image sensor is vibrated or swung in a vertical plane with respect to the incident image light. In more particular, during the periods of the fields A and B, the image sensor stops at two different positions. And during the blanking period, the image sensor reciprocately and radially moves between two different positions. With such an arrangement, the effective horizontal resolution may be doubled without deteriorating the vertical resolution, thus providing a fine and high quality reproduced picture.

Even if the fabrication technique in this field will further be increased and this technique may realize a solid state image sensor of which the picture elements are packed in density two times in horizontal direction, it should be noted that the image sensor as described is advantageous over such image sensor with high integration density and has the following advantages.

(1) in the image sensor with highly density integration, the cell pitch is halved. Therefore, the saturation signal level is remarkably reduced to cause the dynamic range to be excessively narrower. On the other hand, the image sensor as described is free from such problem about the dyanmic range characteristic. Further, it can excellently remove the deterioration of the picture quality (such as smear or blooming) which arises from the diffusion of the signal charge in the substrate when the integration density is increased and hence the distance between the photosensitive portion and the vertical CCD is made small. Thus, the solid state image sensor with a wide dynamic range can be provided without using special and so high fabrication technique.

(2) On the image sensor with high integration density, the read speed of the cell signal (image-sensed signal) is substantially doubled. Many problems undesirably arises from this: for example, increase of power consumption and difficulty in circuit design on the circuits for driving the highly packed image sensor and the peripheral circuits for signal processing. The image sensor as described is free from such problems.

(3) In the image sensor with high integration density, a ratio of each cell area to the substrate area is of necessity small. Accordingly, ratio of the opening area in each cell to the substrate area is also small and is never large. It can not be expected accordingly that the increase of the integration density brings about decrease of the ineffective area in the photosensitive area of such image sensor in collecting light image information. On the other hand, the image sensor is described can substantially collect the light image data from the area corresponding to the actual ineffective area by the vibration of the image sensor per se. Thus, the image sensor as described has an effectively wide area for collecting the optical image information.

As described above, how to set up a relationship between the time variation of position $\phi A$ of the chip substrate of the swinging solid state image sensor and the signal charge read out operation, is one of the most important factor in realizing the high resolution of the reproduced picture.

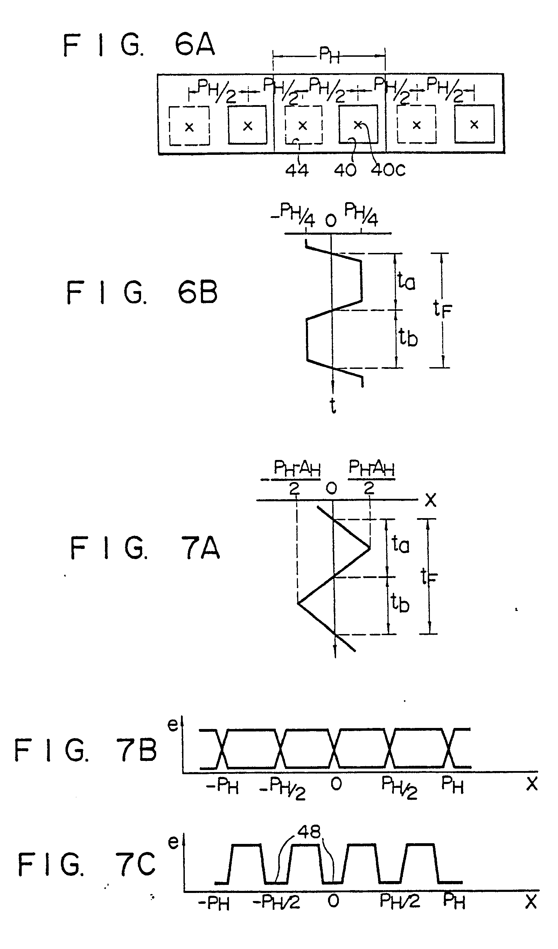

Fig. 6 shows a modification of the swing mode of the aforementioned embodiment. In this swing mode, the opening center 40c in one cell area horizontally swings a distance of $P_H/4$ from its swing center in the positive and negative directions. The other fundamental swinging operations are similar to those in the above embodiment. The waveform on the graph of Fig. 6B, which represents a vibration of IT-CCD, is a trapezoidal waveshape.

A model of the image sensing cells reciprocatingly moving rest at two different positions during both fields A and B when the IT-CCD 10 is vibrated or swinged, is illustrated in Fig. 6A. The cell array as a model in Fig. 6A is illustrated for each frame period. In Fig. 6A, cell positions, as indicated by a solid line during a field A period and as indicated by a dotted line during a field B period, are arranged so as to be distanced by equal pitch length $P_H/2$ from one another. If the IT-CCD 10 is swinged under this cell array condition, it is possible to prevent generation of moiré signal. Therefore, the resolution of the reproduced picture may further be improved.

Turning now to Fig. 7, there is shown still another modification of swing mode of the embodiment shown in Figs. 1 to 5. According to a "triangle swing mode" the IT-CCD horizontally swings with an amplitude $P_H - P_A$, where $A_H$ is a length of opening as horizontally viewed. In the present instance, the swing center of the IT-CCD is just positioned at the coordinate $X=0$ during the vertical blanking period, as in the previous instances. When such "triangle vibration mode" is used, the effective photosensitive cell area is uniformly and continuously expanded within a swing amplitude distance over an entire area of one frame period $t_F$ consisting of two periods of fields A and B, as shown in Fig. 7B. In Fig. 7B, symbol "e" indicates a sensitivity. This arises from the fact that, during one frame period $t_F$, the IT-CCD senses the light image while always moving without the rest of the opening 40. In this instance, therefore, the ineffective area for the image sensing (the area is ineffective in photosensing or image sensing) may be remarkably reduced. When the called "trapezoidal swing mode" already referred to Figs. 4B and 6B is used, extremely low sensitivity areas denoted as 48 are necessarily present. Accordingly, undesirable moiré signal tends to generate. Particularly, when the IT-CCD having a cell opening with a small horizontal length $A_H$ is used, the adverse influence by the false signals is serious. When the "triangle wave swing mode" shown in Fig. 7A is used, however, this problem may easily be solved.

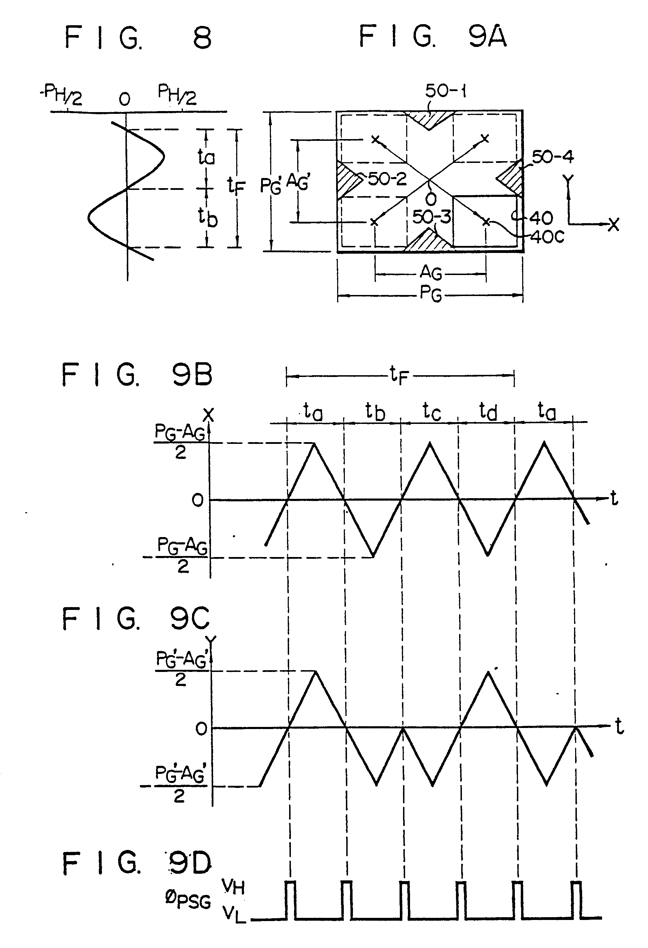

In Fig. 8, there is shown a "sinusoidal wave swing mode", which may be considered as a compromise of the "trapezoidal wave swing mode" and the "triangle wave swing mode". In this instance, the amplitude is $P_H$. This instance may effect the image sensing with small ineffective area.

While having been described using the embodiment applied for the NTSC television system, the present invention is not limited by such instances in any way. In image pick-up systems other than the television system, for example, electronic camera (still camera) not using the silver salt-film and OCR, both being a closed system, the scanning system is not limited by the two-field for one frame. Therefore, if the present invention is applied for such image pick-up system, the resolution is further improved.

Fig. 9 shows a modification of the above-mentioned vibration mode when the present invention is applied for the image pick-up system of the multi-field for one frame type. In this instance, four fields, A, B, C and D make up one frame. The IT-CCD 10 is vibrated radially in four directions about the vibration center 0, corresponding to four field periods, as shown in Fig. 9A. In Fig. 9A, the amplitudes of the X- and Y-axial swing components in the swing mode of this instance are, respectively, $P_G - A_G$ and $P_G' - A_G'$, where $A_G$ is the horizontal (X-axial) width of the cell area and $A_G'$, the vertical (Y-axial) width. The vibration mode components in the respective directions are shown in Figs. 9B and 9C.

By using such vibration mode, four effective image sensing picture elements may be obtained for one real cell during one frame period. A waveform φFSG of the pulse signal or gate control signal applied to FSG 34 (Fig. 1), and a time variation of vibration of the IT-CCD are timed as shown in Fig. 9D, and substantially the same as in Fig. 5. When the gate control signal φFSG is at high voltage level $V_H$, the IT-CCD 10 is positioned at the vibration center 0. A resolution of the reproduced picture is substantially four times that of the conventional IT-CCD which is not swinged for image sensing. In Fig. 9A, ineffective portions 50-1, 50-2, 50-3 and 50-4, which are hatched in illustration, are present. The ineffective portion 50 may easily be improved by a skilled person in the art. For example, all one it may be improved by increasing the area of the opening portion 40.

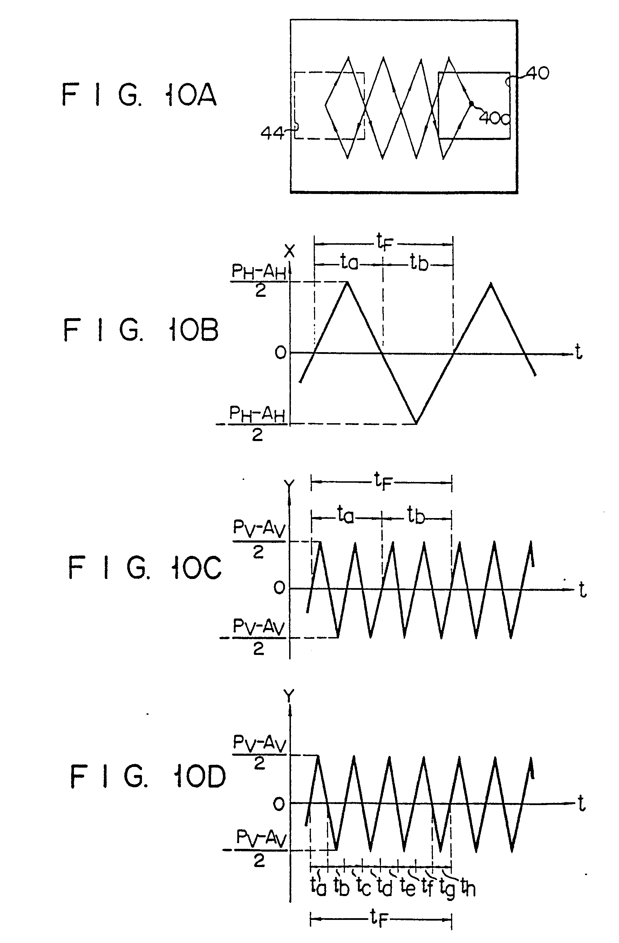

Fig. 10 shows an embodiment of the present invention which is arranged to reduce the ineffective area in the cell of the swinging IT-CCD. As shown in Fig. 10A, the IT-CCD 10 is swinged in a manner that the opening center 40c moves along zig-zag locus so as to have the horizontal swing component and the vertical swing component as well. By using this swing mode, the ineffective area is further decreased. In this case, the swing mode as shown in Fig. 10B is employed for the horizontal swing mode, and is same as that of Fig. 7. The swinging frequency of the vertical component is selected higher than that of the horizontal components, as shown in Fig. 10C. In Fig. 10C, $P_V$ is a vertical pitch length of one cell, and $A_V$ is a vertical length of the opening 40.

Incidentally, in a closed system, the gate control signal with a waveform φFSG like that of the above case is applied to the FSG 34 to read out the signal charge stored in the photosensitive section 32 (Fig. 1) and transfer it to the vertical CCDs $C_1$ to $C_M$, when the vibration center of the vertical swing component is positioned at $Y=0$, as shown in Fig. 10D. Such an arrangement enables one frame to have many fields, for example, 8 fields. In this case, as seen from Fig. 10A, the image-sensed signals obtained from the fields are overlapped one another. Nevertheless, different eight photosensing areas may be obtained from one real photosensitive cell area during one frame period. Therefore, the resolution of the reproduced picture is considerably improved.

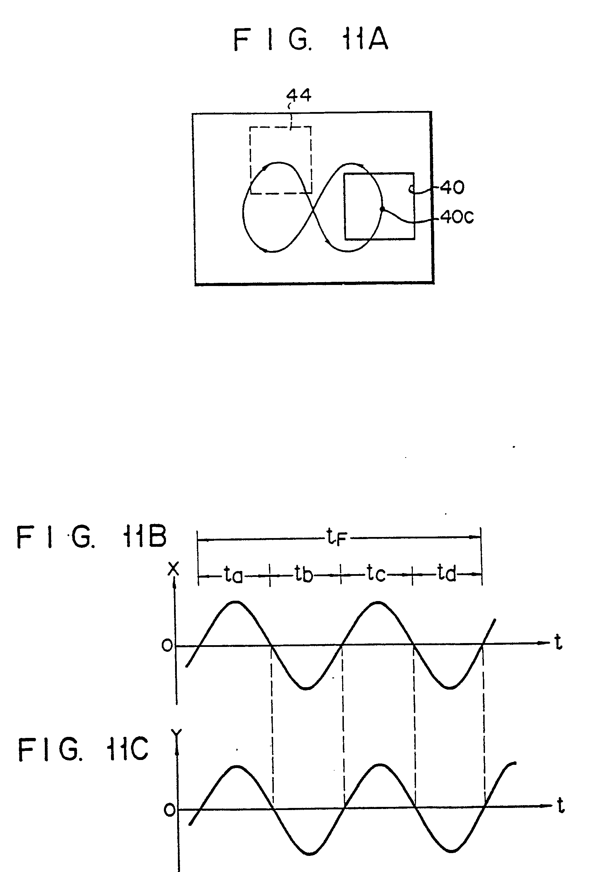

In Fig. 11, the opening 40 is swinged in "8" shape (Fig. 11A) in a plane normal to the incident image light. In the embodiment of Fig. 9, the horizontal or X-axial vibration component may be the called "triangle swing mode" shown in Fig.

9B. The waveform of the Y-axial swing component is a complicated "triangle waveform" as it is returned during the field C period. In the swing mode of Fig. 11A, the swing waveforms in the X- and Y-axial directions are simple sinusoidal waveforms, as shown in Figs. 11B and 11C. Therefore, the swing control of the IT-CCD is simplified.

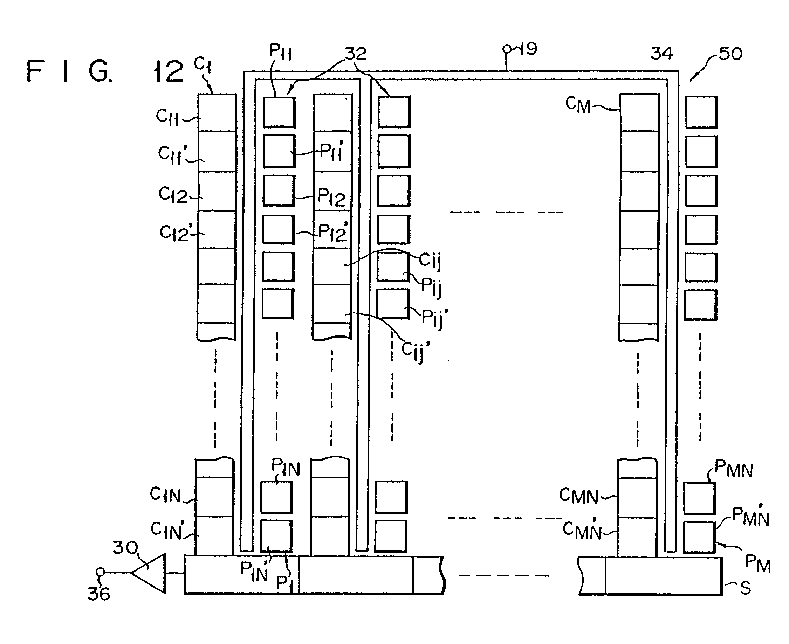

Fig. 12 shows a solid state image sensor including an IT-CCD 50 which is another embodiment of the present invention. The IT-CCD 50 is adaptable for the NTSC system. In Fig. 12, like reference numerals are used for designating like or equivalent portions in Fig. 1. The solid state image sensor is composed of a matrix array of photodiodes or picture element cells P of $2N \times M(N=250$ and $M=400)$. The cell matrix includes columns of the cells $P_1$ to $P_M$. Each cell column contains picture element cells of $2N$ $P_{11}$, $P_{11}'...$, $P_{1N}, P_{1N}',..., P_{MN}, P_{MN}'$. The vertical CCDs $C_1$ to $C_M$ of M are arranged in opposition to the cell columns $P_1$ to $P_M$, with the FSG 34 interposing therebetween. The vertical CCDs $C_1$ to $C_M$ have the same number of transfer stages as the picture elements contained in the cell columns $P_1$ to $P_M$. The first vertical CCD column $C_1$ includes transfer elements of $2N$ $C_{11}$, $C_{11}',..., C_{1N}, C_{1N}'$. The same thing is true for the remaining vertical CCD columns. The signal charges stored in the photocells $P_{11}$, $P_{11}',..., P_{1N}, P_{1N}'$ in each photocell columns $P_1$ to $P_M$ are respectively and independently transferred to the transfer elements $C_{11}$, $C_{11}',..., C_{1N}, C_{1N}'$ in opposition to the vertical CCDs $C_1$ to $C_M$ through the FSG 34, during the horizontal effective period. The signal charges loaded into the vertical CCDs $C_1$ to $C_M$ are successively transferred to every unit of transfer elements of which the number is the same as that of the photocells included in each vertical cell columns. In the horizontal effective period, the charges are further transferred in a horizontal shift register S, and then produced through the amplifier 30 and the output terminal 36 in successive order.

The IT-CCD 50 of Fig. 12 horizontally vibrates or swings in a plane normal to the incident image light and relative to the incident image light, according to the called "trapezoidal wave swing mode". The technique of vibrating the IT-CCD has already been described and hence no further explanation thereof will be given here.

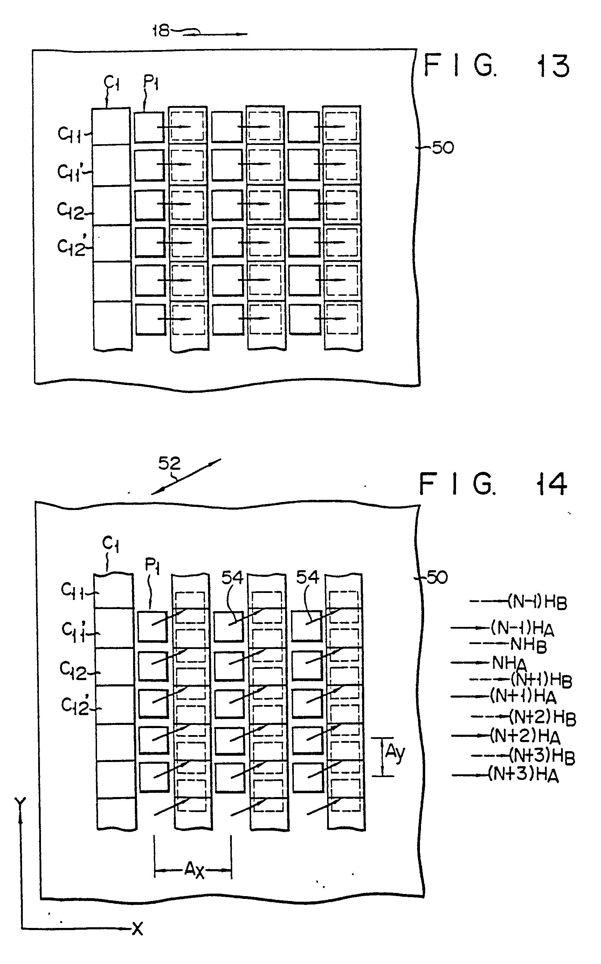

Fig. 13 shows a model of a moving state of the photosensitive section in the horizontal direction when the IT-CCD 50 of Fig. 12 swings in the "trapezoidal wave vibration mode". The amplitude of the vibration is 1/2 of the horizontal picture element pitch. In Fig. 13, during the field A in one frame period, the IT-CCD 50 just rests at a first image sensing position as indicated by a solid line. At the first image sensing position, it senses the incident light image. During the field B period, it rests at the second image sensing position as indicated by a dotted line in Fig. 13. The movement of the signal charges stored in the photocells to the vertical CCDs during each field period, is performed during a period corresponding to the vertical blanking period in the scanning operation at the picture reproducing stage, for executing an effective image sensing operation. Accordingly, during the fields A and B of one frame period, the image information may be obtained at first and second image-sensing positions which are shifted 1/2 pitch of the picture element from one another. Therefore, the present embodiment may attain a high horizontal resolution with the photocells $2N \times M$, or 500, and the horizontal resolution is comparable with that of the high density CCD with 1,000 picture element cells. According to the present embodiment, the signal charges stored in the photocells are independently transferred to the corresponding transfer elements of the vertical CCD, respectively. Therefore, it is prevented that the signal charges from the picture elements adjacent to each other as viewed vertically are mixed when the signal charges are transferred in the vertical CCD. This feature is useful in improving the picture quality or the resolution of the reproduced picture.

Fig. 14 shows an embodiment of the invention which may improve the horizontal resolution and the vertical resolution using a modification of the swing mode shown in Fig. 13. In Fig. 14, the IT-CCD 50 vibrates or swings in a slanted direction denoted as reference numeral 52. Also in this case, the X- and Y-axial swing components have the "trapezoidal wave vibration mode", for example. The X-axial swing component has an amplitude of the half of the photocell pitch length Ax as horizontally viewed. The Y-axial vibration component has an amplitude of the half of the cell pitch Ay as vertically viewed. The movement of the photocell $P_{ij}$ of the IT-CCD 50 vibrating in such vibration mode is indicated by an arrow 54. During the field A period, each of picture element cells rests at a first image sensing position as indicated by a solid line in Fig. 14 and the image sensing is thus performed at this position. During the field B period, the cells stop and rest at a second image sensing position as indicated by a dotted line, which is different from the first image sensing position in the Fig. 13 embodiment. During this period, the image sensing is performed at this position. This operation is repeated every frame period.

For reproducing the image signal obtained according to the present image sensing system, the field image read out in synchronism with the read out clock in the fields A and B may easily provide a normal reproduced picture by vertically shifting them by the 1/2 picture element period. According to this image sensing system, as shown in Fig. 14, the field image signal components $(N-1)H_A$, $NH_A$, $(N+1)H_A$, $(N+2)H_A$, $(N+3)H_A$,... are read out in the field A period. In the field B period, the field picture signal components $(N-1)H_B$, $NH_B$, $(N+1)H_B$, $(N+2)H_B$, $(N+3)H_B$,... are read out. Therefore, the interlacing image sensing is performed not only in the horizontal direction but also in the vertical direction, corresponding to the interlacing scanning in

the picture display. Almost ideal interlacing image sensing is possible, accordingly. Thus, a high vertical resolution comparable with that as given by 1,000 vertical scanning lines can be attained. Further, the horizontal resolution may be improved doubly.

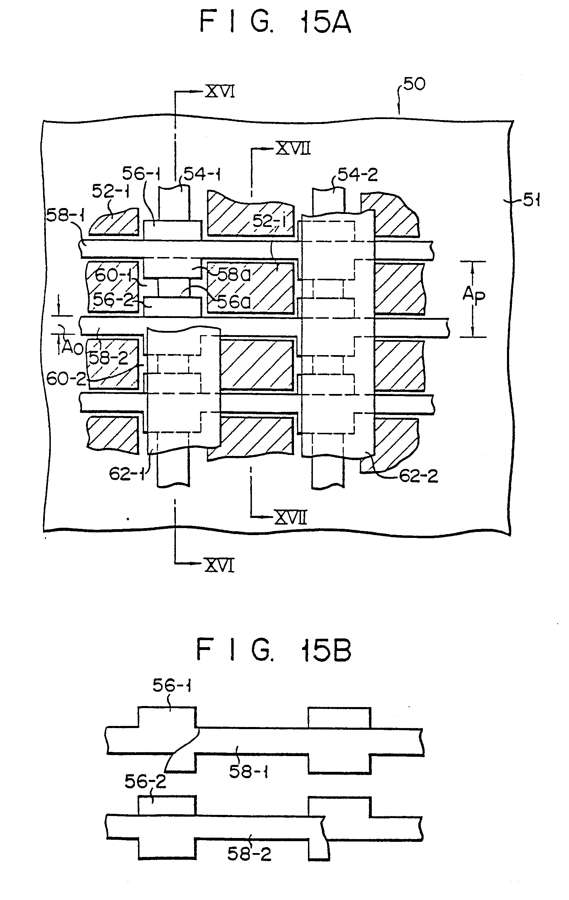

A practical arrangement of the IT-CCD 50, which is well adaptable for the two embodiments shown in Figs. 12 to 14, will be described referring to Fig. 15 to 17. Fig. 15A is a plan view of a planar structure of a part of the IT-CCD 10 formed on the substrate 51. In the figure, the photodiode areas 52-1,..., 52-i,... serving as photocells are shaded only for ease of illustration. Vertical CCD channels 54-1, 54-2,... extend between cell columns including the cell regions 52-1,..., 52-i on the substrate 51 in parallel fashion. Formed on the vertical CCD channels 54-1, 54-2,... are first transfer electrodes 56-1, 56-2,... forming a first layer, which extend normal to the CCD channels 54-1, 54-2,... Second transfer electrodes 58-1, 58-2,... forming a second layer are further formed on the first transfer electrodes 56-1, 56-2,... The planar structure of the first and second transfer electrodes 56 and 58 are clearly illustrated in an enlarged manner in Fig. 15B. A gap 60-1 extends between a convex portion 58a of the second transfer electrode 58-1 and a convex portion 56a of the first transfer electrode 56-2. The gap 60-1 is located at about mid-point in the width $A_p$ of the cell column in the vertical direction. The remaining electrodes are also arranged in a similar fashion. In Fig. 15A, only one of the other gaps is typically illustrated using reference numeral 60-2. Third electrode layers 61-2, 62-2,... are formed on the columns of the convex portion 58a,...

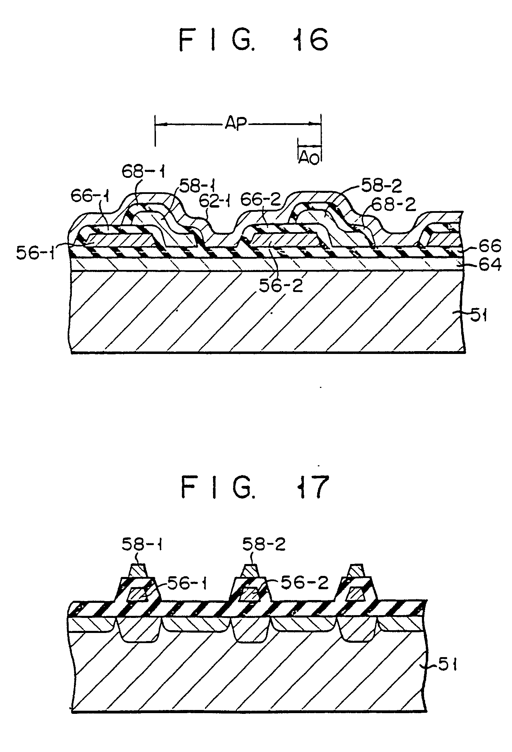

Fig. 16 shows a cross sectional view of the IT-CCD 50 taken on line XVI—XVI in Fig. 15A. An $N^+$ layer 64 serving as a buried channel is deposited on the top surface of the substrate 51 made of P type silicon, for example. A gate oxide film 66 is deposited on the $N^+$ layer 64. The first transfer electrodes 56-1, 56-2,... are formed on the gate oxide film 66. The second transfer electrodes 58-1, 58-2,... partially overlay the first transfer electrodes 56-1, 56-2,..., through insulative films 66-1, 66-2,... The overlaying portion of these electrodes are denoted as Ao. After insulative films 68-1, 68-2,... are formed on the structure, the electrode layer 62-1 is deposited.

Three phase clock pulse voltages are applied to the first to third transfer electrodes 56, 58 and 62, respectively. With the application of the pulse voltages, a transfer element or a transfer unit is formed, which is composed of the first transfer electrode 56-2, the second transfer electrode 58-1, and the third transfer electrode 62-1 between the adjoining first and second transfer electrodes. The transfer unit corresponds to one transfer stage of the vertical CCD. The cross sectional structure of the IT-CCD 50 taken along line XVII—XVII in Fig. 15A, has a simple structure in which the first transfer electrodes 56-1, 56-2,... and the second transfer electrodes 58-1, 58-2,... are laid one upon another, as shown in Fig. 17.

The IT-CCD 50 thus arranged is simple in construction and has little deterioration of sensitivity, and is preferable.

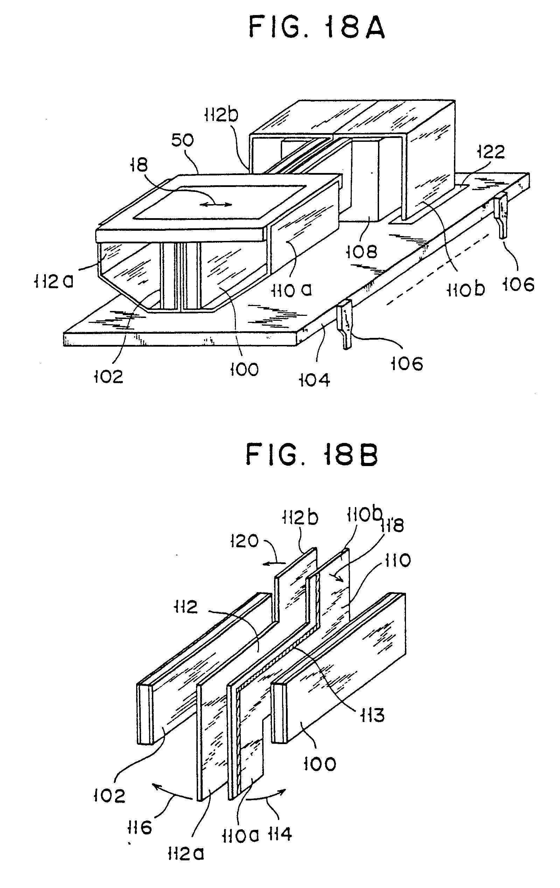

In Fig. 18, there is schematically shown an embodiment of an image sensor driving device (deflection device) for vibrating the Fig. 12 IT-CCD 50 in the vibration mode shown in Fig. 13. The IT-CCD 50 is driven to vibrate in the horizontal direction by rectangular bimorph piezoelectric elements (e.g. ceramic) of the open side type.

In Fig. 18A, a plate base (referred to as a "mother board" hereinafter) 104 has at both side edges a plurality of electrode pins 106 coupled with an external IC socket (not shown). A support table 108 is fixed on the mother board 100. The plate like bimorph piezoelectric elements 100 and 102 are fixed at one ends thereof to the support table 108 by means of adhesive, for example. As shown in Fig. 18B, the piezoelectric elements 100 and 102 are firmly bonded to each other, having flexible print circuited substrates (referred to as "film connectors" hereinafter) 110 and 112 sandwiched therebetween. The film connectors 110 and 112 electrically connect the IT-CCD 50 to the electrode pins 106 of the mother board 104. With this connection, the image-sensed signal derived from the IT-CCD 50 is supplied t the electrode pins 106. The rectangular piezoelectric elements 100 and 102 are fixed to the support table 108 substantially orthogonal to the top surface of the mother board 104. Accordingly, the piezoelectric elements 100 and 102 are allowed to vibrate at the free ends thereof in the horizontal direction as indicated by an arrow 18. The piezoelectric elements 100 and 102 are provided at the principal surfaces with electrodes (not shown). These elements 100 and 102 are connected through the electrodes to an external circuit.

The IT-CCD 50 is bonded to the side faces of the free ends of the pair of piezoelectric elements 100 and 102. The film connectors 110 and 112 are formed to substantially have a letter "Z" shape. Wiring patterns 113 extend along the stepped portions on the surface of the film connectors 110 and 112. End portions 110a and 112a of the film connectors 110 and 112 are bent in the directions of arrows 114 and 116, as shown in Fig. 18B. The bent end portions 110a and 112a are mounted on both sides of the IT-CCD 50 which are opposite to each other, as shown in Fig. 18A. The other end portions 110b and 112b of the film connectors are bent in the directions of arrows 118 and 120, as shown in Fig. 18B, and are connected to the connection area of the mother board 104, as shown in Fig. 18A. The connection area of the mother board 104 is electrically connected to the pins 106 by printed patterns (not shown) on the mother board 104. With this arrangement, the image-sensed signals derived from the IT-CCD 50 are supplied to the pins 106, through the film connectors 110 and 112. The structure thus arranged is packed in a package (not shown).

The image sensor deflection device thus constructed may effectively swing the IT-CCD 50 in the above-mentioned swing mode. As described above, the main portions of the film connectors 110 and 112, connecting the IT-CCD 50 and the pins 106, are layered and sandwiched between the pair of the piezoelectric plates 100 and 102. This feature prevents the vibration or swing range of the IT-CCD 50 from being limited by the film connectors 110 and 112. In other words, the film connectors 110 and 112 are arranged so as not to be a real load for the CCD vibration. Therefore, the IT-CCD 50 may be effectively swinged by the bimorph piezoelectric elements 100 and 102.

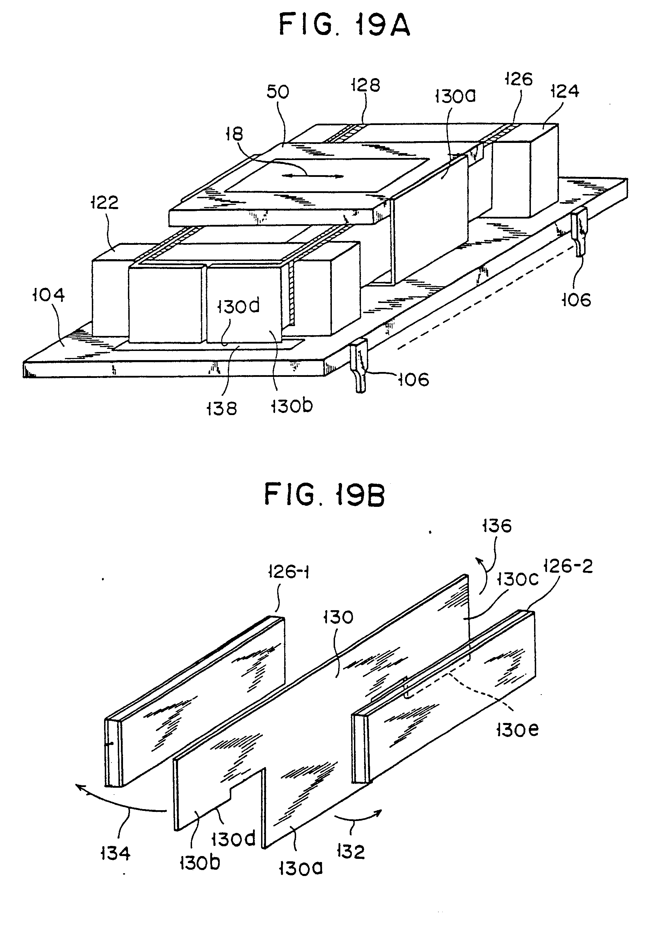

Fig. 19 shows another embodiment of the invention so arranged as to vibrate or swing the IT-CCD 50 using a bimorph vibrating element of the both-end support type. A couple of support tables 122 and 124 are fixed in a face-to-face fashion on the top surface of the mother board 104. A couple of rectangular plate like bimorph piezoelectric elements 126 and 128 are fixed by the support tables 122 and 124 in a manner that their principal surfaces are faced with each other. That is, the piezoelectric plate 126 is fixed at both ends by the two support tables 122 and 124 using adhesive, for example. The piezoelectric plate 126 is disposed substantially normal to the mother board 104. The piezoelectric plate 128 is also fixedly supported at both ends by the support tables 122 and 124, and are disposed substantially in parallel with the piezoelectric plate 126. Therefore, both the piezoelectric plates 126 and 128, vibrating in the same swing mode or in a synchronized manner, serve as displacement generating elements with both ends supported.

The piezoelectric plate 126 is made up of a couple of elemental piezoelectric plates 126-1 and 126-2. These elemental plates 126-1 and 126-2 are bonded to each other to have the film connector 130 inserted therebetween. The connector 130 is substantially T-shaped. Its first end portion 130a is bent to the direction of an arrow 132, and is mounted to the one of the sides of the IT-CCD 50. Second and third end portions 130b and 130c of the film connector 130 are bent to the directions of arrows 134 and 136, respectively. The film connector 130 is connected at their end faces 130d and 130e to a connection area 138 formed on the top surface of the mother board 104. The other piezoelectric plate 128 is also constructed in a similar fashion.

The IT-CCD 50 is bonded to the intermediate portions of the side faces of the piezoelectric plates 126 and 128. With this arrangement, the IT-CCD 50 is swinged in the horizontal direction of an arrow 18 with the vibration of the piezoelectric elements 126 and 128. Therefore, unlike the embodiment of Fig. 18, the IT-CCD 50 may exactly be swinged in the horizontal direction. Since the two piezoelectric elements 126 and 128 are used, the IT-CCD 50 is stably fixed thereon and its manufacturing is easy.

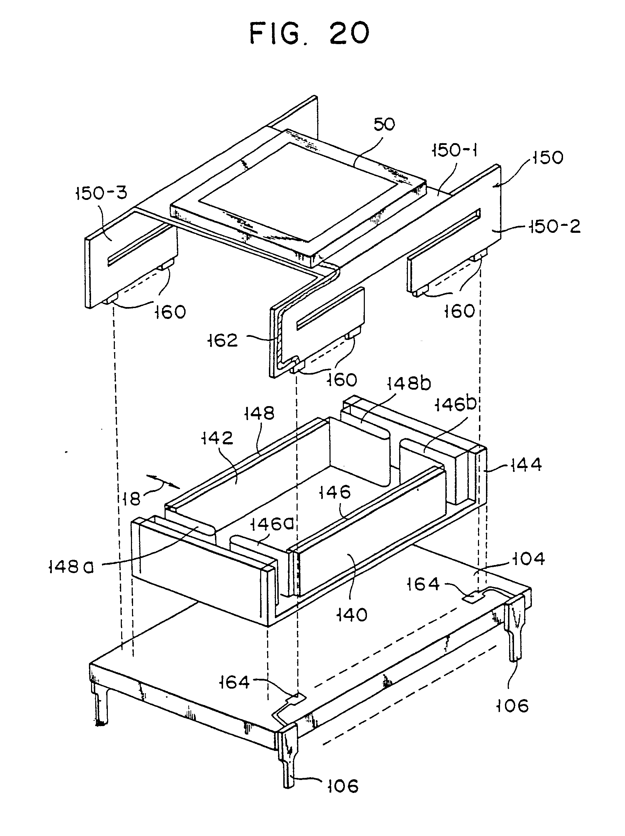

In an embodiment of Fig. 20, two rectangular plate like bimorph piezoelectric elements 140 and 142 are mounted to a frame 144 fixed to the top surface of the mother board 104 through a resilient support plates 146 and 148. Conventional piezoelectric ceramic material of ternary system piezoelectric ceramics was used for the piezoelectric elements 140 and 142. The piezoelectric plates 140 and 142 were each formed by sticking together two piezoelectric ceramic plates of 5 mm in width, 18 mm in length and 0.15 mm in thickness. The support plates 146 and 148 are each formed by working a nickel plate of 5 mm in width and 50 µm in thickness so as to have a maximum of its displacement. The support plate 146 has bent portions 146a and 146b serving as spring at locations near its both ends. The other support plate 148 has likewise bent portions 148a and 148b. The piezoelectric plates 140 and 142 are fixed at the intermediate portions of the resilient support plates 146 and 148. The piezoelectric elements 140 and 142 thus constructed are arranged to be in parallel with each other and to vibrate in the direction of an arrow 18 together. An electric field applied to the piezoelectric elements 140 and 142 are controlled so that these plates vibrate in the same vibration mode (having the displacements and directions at a time point).

A film connector 150 is sticked to the rear surface of the IT-CCD 50. The film connector 150 is made up of a main body 150-1, a pair of C-shaped legs 150-2 and 150-3 integrally connected to both ends of the main body 150-1, and a plurality of connecting portions 160 made of rubber and connected to the C-shaped legs 150-2 and 150-3. In the legs 150-2 and 150-3, a necessary number of wiring patterns 162 extends following the configuration. The IT-CCD 50 is bonded to the side faces of the two piezoelectric plates 140 and 142, through the film connector 150. At this time, the C-shaped legs 150-2 and 150-3 of the film connector 150 are bent, whereby the connecting portions 160 are electrically connected, in one-to-one correspondence, to the printed patterns 164 provided on the top surface of the mother board 104 corresponding to the pins 106.

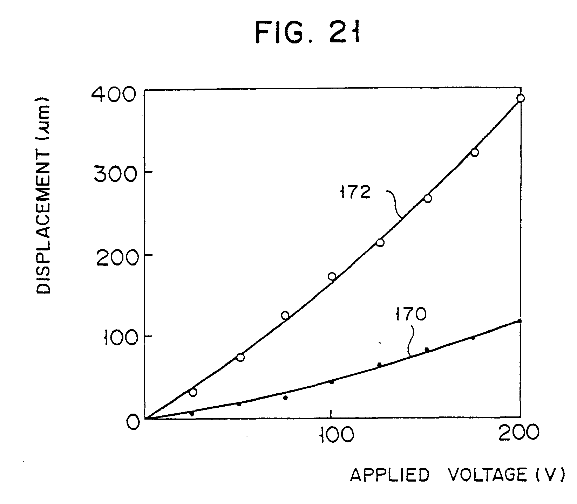

According to the embodiment of Fig. 20, the piezoelectric elements 140 and 142 are mounted in a floating manner to the frame 144, through support plates 146 and 148 having a spring function. The piezoelectric plates 140 and 142 are structured such that these are substantially floated in space, having essentially no portion fixedly coupled with other members. This unique structure of the plates remarkably increases an amount of their displacement in the vibration of the piezoelectric elements 140 and 142. This means that the present embodiment is well adaptable for the case to vibrate or swing a relatively heavy object (e.g. 5g) such as the IT-CCD 50. Fig. 21 illustrates a graph of experimental data displacements given by the conventional bimorph piezoelectric element of the both-end supporting type and by the bimorph piezoelectric element of the open-end type of this invention with respect to the applied voltage. In the figure, a. curve 170 indicate a variation of the displacement by the conventional piezoelectric element of the both-end supporting type, and a curve 172 indicates a variation of the displacement by the floating type piezoelectric elements 140 and 142 of this invention. As seen from Fig. 21, in the Fig. 20 embodiment, a displacement corresponding to an amplitude of the drive force for swinging the IT-CCD 50 is about three times larger than that by the piezoelectric element of the both-end supporting type.

Although the present invention has been shown and described with respect to particular embodiments, nevertheless, various changes and modifications which are obvious to a person skilled in the art to which the invention pertains are deemed to lie within the scope of the invention.

The present invention, which has been described using the IT-CCD, may of course be embodied using a frame transfer CCD (FT-CCD) as described in a paper bearing a title "512×340 Picture Elements Image Sensor" in Journal of Television Institute, pp. 536 to 541, July, Vol. 33, No. 7. A common point in the image sensing operation by the solid state image sensor chip substrate between these CCD systems resides in that the signal charges stored in the photosensitive portion of each cell are simultaneously read out during the vertical blanking period. This fact implies that the solid state image sensor chip substrate, if it has the function resemble with that of these CCD systems, may be used for the present invention. In the above-mentioned embodiments, the shape of the opening 40 was rectangular for ease of explanation. If the opening has other shapes, the number of the sampling points are not decreased. Such shapes may of course be involved in this invention. The IT-CCD shown in Figs. 2 and 3 employs photosensitive cells $P_{ij}$, $P_{ij}'$ vertically arrayed in a line in each cell column, as described above. The photosensitive cells may be arrayed in a zig-zag fashion. The zig-zag arrayed photosensitive portions will further improve the resolution in question.

It is evident that this invention is applicable for a color television camera with one, two or three image sensors. If the combination of this invention and the picture elements swinging method as mentioned above is applied for the two- or three-plate television camera, the resolution is further improved.

The amplitude of the vibration is shorter than the cell pitch in the aforementioned embodiments. In the single-plate color television camera, the picture element pitch is longer than that of the above-mentioned case. Therefore, if the present invention is applied for the single-plate color television camera, it is preferable to extend the swing amplitude up to the distance between the adjacent cells, for lessening the moiré signals produced for the color signal. The present invention may change the vibration amplitude so long as the high resolution is kept.

The present invention is also applicable for a called two-stage sensor in which a photoconductive film is used for the photoelectric conversion, and the conventional silicon single crystal substrate, for example, is used for the read scanning.

In the Figs 4 to 11 embodiments, the time point of the signal charge shift from the photosensitive portions to the vertical CCDs $C_1$ to $C_M$ is exactly coincident with the time that the vibrating the IT-CCD passes the vibration center. This time coincidence between them is not essential in the present invention, however. In contract with this, these timings may be shifted positively. If so, the increased sensitivities of the picture elements of the vibrating CCD are superposed to prevent undesirable phenomenon originating from the false signal generation, such as moiré.

**Claims**

1. A device for sensing an incident light image (16) comprising a solid state image sensing device (10, 50) which senses a light image compatible with a predetermined television system in which one frame includes a plurality of fields including first and second fields, said image sensing device (10, 50) comprising sensing means (32) for receiving radiation (16) representing image information and for generating and storing charges corresponding to the radiation (16), said sensing means (32) including at least one linear cell array (P1,..., PM) containing a predetermined number of cells (Pij, Pij'), and transfer means (C) disposed adjacent to said sensing means (32) for reading out and transferring the charges stored in said sensing means (32), said transfer means (C) including at least one linear transfer section (C1,..., CM) extending along said linear cell array (P1,..., PM), and wherein a displacement generating means (12, 100, 102, 126, 128, 140, 142) is mechanically coupled to said image sensing device (10, 50), for swinging said image sensing device (10, 50) in such a manner that the image sensing device relatively moves in a plane substantially orthogonal to the direction of the incident radiation and each cell is located at different sensing positions during different field periods in one frame period of the television system, whereby signal charges collected during the first field period are simultaneously read out from said cell array (P1,..., PM) to said transfer section (C1,..., CM) before said each cell is located at the following position for storing signal charges corresponding to an image of the second field, so that the image resolution of the frame image is improved.

2. A device as claimed in claim 1, characterized in that said transfer section includes transfer stages with the same number as that of cells (Pij, Pij') contained in said linear cell array (P1,..., PM).

3. A device as claimed in claim 1 or claim 2 characterised in that said sensing means (32) comprises a photosensing region (32) formed on a surface of a substrate (51) which forms part of said image sensing device and wherein said displacement generating means (12, 100, 102, 126, 128, 140, 142) is mechanically coupled to said substrate (51).

4. A device as claimed in any one of claims 1 to 3 wherein said sensing means (32) includes a

plurality, M, of said linear cell arrays (P1,..., PM) disposed in parallel with each other and each of which has 2N photocells linearly arrayed and said transfer means (c) comprises a respective plurality, M, of said linear transfer sections (C1,..., CM), each transfer section being disposed adjacent to a respective transfer array.

5. A device as claimed in claim 4, characterised in that, when said television system is the NTSC system, said displacement generating means (12, 100, 102, 126, 128, 140, 142) reciprocately moves said substrate (51) of said image sensing device (10, 50) in said plane so as to make each of said cell arrays (P1,..., PM) rest at a first image sensing position during a first field image sensing period (ta), and to make each of said cell columns rest at a second field image sensing position during a second field image sensing period (tb).

6. A device as claimed in claim 5, characterised in that said image sensing device (10, 50) further comprises field shift gate means (34) formed on said substrate surface and extending along said M cell arrays (P1,..., PM) and said M charge transfer sections (C1,..., CM), and having M field shift gate sections electrically connected to one another, and for simultaneously transferring to said charge transfer sections (C1,..., CM) signal charges stored in said cell arrays (P1,..., PM) substantially in synchronism with a rapid movement of each of said cell arrays (P1,..., PM) between said first and second image sensing positions.

7. A device as claimed in claim 6, characterised in that each of said charge transfer sections (C1,..., CM) has the same number of transfer elements, 2N, as that of said photocells contained in each of said cell arrays (P1,..., PM), whereby the signal charges stored in said photocells of each of said cell arrays (P1,..., PM) are transferred to said transfer elements by said field shift gate means (34), respectively.

8. A device as claimed in claim 4, characterised in that, when said television system is NTSC system, said displacement generating means (12, 100, 102, 126, 128, 140, 142) swings said substrate (51) of said image sensing device (10, 50) in said plane so as to substantially always move between said first and second positions in a reciprocal manner, whereby said cell arrays (P1,..., PM) perform the image sensing operation during one frame period (tF), while substantially moving.

9. A device as claimed in claim 8, characterised in that said image sensing device (10, 50) further comprises field shift gate sections (34) formed on said substrate surface and extending along said M cell arrays (P1,..., PM) and M charge transfer sections (C1,..., CM) and connected electrically to one another, said field shift gate sections simultaneously transferring the signal charges which are stored in said cell arrays (P1,..., PM) substantially at the time that each of said cell arrays (P1,..., PM) reaches the substantially center position between said first and second positions.

10. A device as claimed in claim 9, characterised in that each of said charge transfer sections (C1,..., CM) has the same number of transfer elements, 2N, as that of said photocells contained in each of said cell arrays (P1,..., PM), whereby the signal charges stored in said photocells of each of said cell arrays (P1,..., PM) are transferred to said transfer elements by said field shift gate means (34), respectively.

11. A device as claimed in claim 7, characterised in that said cell arrays (P1,..., PM) are arranged equidistantly, and wherein said displacement generating means (12, 100, 102, 126, 128, 140, 142) swings said substrate (51) in said plane and in the direction substantially orthogonal to the extending direction of said cell arrays (P1,..., PM), and in a manner that a distance between said first and second image sensing positions is preferably half of the interval of said cell arrays (P1,..., PM).

12. A device as claimed in claim 7, characterised in that said cell arrays (P1,..., PM) are arranged equidistantly, and that said deflection means (12, 100, 102, 126, 128, 140, 142) swings said substrate (51) in said plane, in the direction oblique to the extending direction of said cell arrays (P1,..., PM), and so that a first distant component of the distance between said first and second image sensing positions, which is directed normal to said cell column extending direction, is preferably equal to the half of the interval between said cell arrays (P1,..., PM), and a second distance component in the extending direction of said cell arrays (P1,..., PM) is preferably equal to the half of the pitch of said photocells (Pij, Pij') of 2N contained in each of said cell arrays (P1,..., PM).

13. A device as claimed in any one of the preceding claims characterised in that said displacement generating means comprises at least one piezoelectric element (100, 102, 126, 128, 140, 142).

14. A device as claimed in any one of claims 1 to 12, charcterised in that said displacement generating means includes a rectangular piezoelectric plate (100, 102, 126, 128, 140, 142) of piezoelectric material.

15. A device as claimed in claim 14, characterised by further comprising: a mother board (104) made of electrically conductive material and with a plurality of pins (106); supporting means (108, 124, 146, 148) for stably supporting said piezoelectric plate (100, 102, 126, 128, 140, 142) on said mother board (104) to allow said piezoelectric plate (100, 102, 126, 128, 140, 142) mechanically coupled with said image sensing device (50) to vibrate according to externally applied electrical signal; and flexible connecting means (110, 112, 130, 150) extending on that when said piezoelectric plate (100, 102, 126, 128, 140, 142) vibrates, it does not apply to the vibration a real load serving to attenuate the vibration, said connecting means electrically connecting said image sensing device (50) to said pins (106).

16. A device as claimed in claim 15, characterised in that said connecting means includes a film connector (110, 112, 130, 150) with a main portion extending closest to said piezoelectric plate (100, 102, 126, 128, 140, 142).

17. A device as claimed in claim 16, characterised in that said drive means includes two rectangular piezoelectric plates (140, 142), and said supporting means includes supporting plate (146, 148) for supporting said piezoelectric plates (140, 142) in substantially parallel with each other and substantially normal to said mother board (104), and for resiliently supporting said piezoelectric plates (140, 142) at both ends of said piezoelectric plates (140, 142) as viewed longitudinally, said piezoelectric plates (140, 142) vibrate in the same vibration mode and in the direction of the thickness of said piezoelectric plates (140, 142) per se.

18. A device as claimed in claim 17, characterised in that said piezoelectric plates (140, 142) have respectively side edges to which said image sensing device (50) is fixed at the rear surface.

19. A device as claimed in claim 16, characterised in that a main portion of said film connector (110, 112, 130, 150) is stuck to said piezoelectric plate and vibrates in accordance with the vibration of said piezoelectric plates.

**Patentansprüche**

1. Vorrichtung zum Messen oder Abgreifen eines einfallenden Lichtbilds (16) mit einer Festkörperbildsensorvorrichtung (10, 50), die ein(e) Lichtbild oder -abbildung abgreift, welche(s) mit einem vorbestimmten Fernsehsystem kompatibel ist, in welchem ein Halbbild mehrere Teilbilder, einschließlich erster und zweiter Teilbilder, enthält, wobei die Bildsensorvorrichtung (10, 50) eine Meß- oder Sensoreinheit (32) zum Empfangen von Strahlung (16), welche eine Bildinformation darstellt, und zum Erzeugen und Speichern von Ladungen entsprechend der Strahlung (16) aufweist, wobei die Sensoreinheit (32) mindestens ein lineares Zellenarray (P1,..., PM), enthaltend eine vorbestimmte Zahl von Zellen (Pij, Pij'), sowie eine neben der Sensoreinheit (32) angeordnete Übertragungseinheit (C) zum Auslesen der in der Sensoreinheit (32) gespeicherten Ladungen und zum Übertragen derselben aufweist, die Übertragungseinheit (C) mindestens einen längs des linearen Zellenarrays (P1,..., PM) verlaufenden linearen Übertragungsabschnitt (C1,..., CM) enthält, und wobei eine Verschiebungserzeugungseinrichtung (12, 100, 102, 126, 128, 140, 142) mit der Bildsensorvorrichtung (10, 50) mechanisch gekoppelt ist, um die Bildsensorvorrichtung (10, 50) in der Weise zu verschwenken oder schwingen zu lassen, daß die Bildsensorvorrichtung eine Relativbewegung in einer im wesentlichen orthogonal zur Richtung der einfallenden Strahlung liegenden Ebene ausführt und jede Zelle in unterschiedlichen Meßpositionen während verschiedener Teilbildperioden in einer Bildperiode des Fernsehsystems angeordnet ist, wobei während der ersten Teilbildperiode gesammelte Signalladungen gleichzeitig aus dem Zellenarray (P1,..., PM) zum Übertragungsabschnitt (C1,..., CM) ausgelesen werden, bevor jede Zelle an der folgenden Position angeordnet ist, um Signalladungen entsprechend einem Bild des zweiten Teilbilds zu speichern, so daß damit eine Bildauflösung des Halbbild-Bilds verbessert ist.

2. Vorrichtung nach Anspruch 1, dadurch gekennzeichnet, daß der Übertragungsabschnitt Übertragungsstufen mit derselben Zahl wie diejenige der im linearen Zellenarray (P1,..., PM) enthaltenen Zellen (Pij, Pij') aufweist.

3. Vorrichtung nach Anspruch 1 oder 2, dadurch gekennzeichnet, daß die Sensoreinheit (32) einen auf einer Fläche eines Substrats (51), das einen Teil der Bildsensorvorrichtung bildet, ausgebildeten Photosensorbereich (32) aufweist und daß die Verschiebungserzeugungseinrichtung (12, 100, 102, 126, 128, 140, 142) mit dem Substrat (51) mechanisch gekoppelt ist.

4. Vorrichtung nach einem der Ansprüche 1 bis 3, dadurch gekennzeichnet, daß die Sensoreinheit (32) eine Anzahl M von linearen Zellenarrays (P1,..., PM) aufweist, die parallel zueinander angeordnet sind und jeweils 2N von linear angeordneten Photozellen aufweisen, und die Übertragungseinheit (C) eine entsprechende Zahl M von linearen Übertragungsabschnitten (C1,..., CM) aufweist, wobei jeder Übertragungsabschnitt neben einem entsprechenden Übertragungsarray (Zellenarray) angeordnet ist.

5. Vorrichtung nach Anspruch 4, dadurch gekennzeichnet, daß dann, wenn das Fernsehsystem das NTSC-System ist, die Verschiebungserzeugungseinrichtung (12, 100, 102, 126, 128, 140, 142) das Substrat (51) der Bildsensorvorrichtung (10, 50) hin- und hergehend in der (genannten) Ebene bewegt, um jedes der Zellenarrays (P1,..., PM) während einer ersten Teilbild-Bildabtastperiode (ta) an einer ersten Bildabgreifposition zur Ruhe kommen zu lassen und jede der Zellenspalten bzw. jedes Zellenarray während einer zweiten Teilbild-Bildabgreifperiode (tb) an einer zweiten Teilbild-Bildabgreifposition zur Ruhe kommen zu lassen.

6. Vorrichtung nach Anspruch 5, dadurch gekennzeichnet, daß die Bildsensorvorrichtung (10, 50) weiterhin eine auf der Substratoberfläche ausgebildete und sich längs der M Zellenarrays (P1,..., PM) sowie der M Ladungsübertragungsabschnitte (C1,..., CM) erstreckende Teilbild-Schiebegliedeinheit (34) mit M elektrisch miteinander verbundenen Teilbild-Schiebegliedabschnitten aufweist, zum gleichzeitigen Übertragen von in den Zellenarrays (P1,..., PM) gespeicherten Signalladungen zu den Ladungsübertragungsabschnitten (C1,..., CM) praktisch in Synchronismus mit einer schnellen Bewegung jedes der Zellenarrays (P1,..., PM) zwischen den ersten und zweiten Bildabgreifpositionen.

7. Vorrichtung nach Anspruch 6, dadurch gekennzeichnet, daß jeder der Ladungsübertragungsabschnitte (C1,..., CM) dieselbe Zahl 2N von Übertragungselementen aufweist, wie die Zahl der in jedem der Zellenarrays (P1,..., PM) enthaltenen Photozellen beträgt, wobei die in den Photozellen jedes der Zellenarrays (P1,..., PM) gespeicherten Signalladungen jeweils durch die Teilbild-Schiebegliedeinheit (34) zu den Übertragungselementen übertragen werden.

8. Vorrichtung nach Anspruch 4, dadurch gekennzeichnet, daß dann, wenn das Fernsehsystem das NTSC-System ist, die Verschiebungserzeugungseinrichtung (12, 100, 126, 128, 140, 142) das Substrat (51) der Bildsensorvorrichtung (10, 50) in der (genannten) Ebene so verschwenkt oder schwingen läßt, daß es sich praktisch ständig hin- und hergehend zwischen den ersten und zweiten Positionen bewegt, wobei die Zellenarrays (P1,..., PM) die Bildabgreifoperation während einer Halbbildperiode (tF) durchführen, während sie sich praktisch bewegen.

9. Vorrichtung nach Anspruch 8, dadurch gekennzeichnet, daß die Bildsensorvorrichtung (10, 50) fener auf der Substratoberfläche ausgebildete und sich längs der M Zellenarrays (P1,..., PM) sowie längs der M Ladungsübertragungsabschnitte (C1,..., CM) erstreckende und elektrisch miteinander verbundene Teilbild-Schiebegliedabschnitte (34) aufweist, welche gleichzeitig die in den Zellenarrays (P1,..., PM) gespeicherten Ladungen praktisch zu dem Zeitpunkt übertragen, zu dem jedes der Zellenarrays (P1,..., PM) im wesentlichen die Mittenstellung zwischen ersten und zweiten Positionen erreicht.

10. Vorrichtung nach Anspruch 9, dadurch gekennzeichnet, daß jeder der Ladungsübertragungsabschnitte (C1,..., CM) dieselbe Zahl 2N von Übertragungselementen aufweist, wie die Zahl der in jedem Zellenarray (P1,..., PM) enthaltenen Photozellen beträgt, wobei die in den Photozellen jedes der Zellenarrays (P1,..., PM) gespeicherten Signalladungen jeweils durch die Teilbild-Schiebegliedeinheit (34) zu den Übertragungselementen übertragen werden.

11. Vorrichtung nach Anspruch 7, dadurch gekennzeichnet, daß die Zellenarrays (P1,..., PM) auf gleiche Abstände verteilt angeordnet sind und daß die Verschiebungserzeugungseinrichtung (12, 100, 102, 126, 128, 140, 142) das Substrat (51) in der (genannten) Ebene und in der Richtung im wesentlichen orthogonal zur Verlaufsrichtung der Zellenarrays (P1,..., PM) und in der Weise verschwekt oder schwingen läßt, daß ein Abstand zwischen den ersten und zweiten Bildabgreifpositionen vorzugsweise die Hälfte des Abstands der Zellenarrays (P1,..., PM) beträgt.

12. Vorrichtung nach Anspruch 7, dadurch gekennzeichnet, daß die Zellenarrays (P1,..., PM) auf gleiche Abstände verteilt sind und daß die Ablenkeinrichtung (12, 100, 102, 126, 128, 140, 142) das Substrat (51) in der (genannten) Ebene in der Richtung schräg zur Verlaufsrichtung der Zellenarrays (P1,..., PM) und so verschwenkt oder schwingen läßt, daß eine erste Distanzkomponente der Distanz zwischen den ersten und zweiten Bildabgreifpositionen, die senkrecht zur Zellenspalten- oder -array-Verlaufsrichtung liegt, vorzugsweise gleich der Hälfte des Abstands zwischen den Zellenarray (P1,..., PM) ist und eine zweite Distanzkomponente in der Verlaufsrichtung der Zellenarrays (P1,..., PM) vorzugsweise gleich der Hälfte des Teilungsabstands der in jedem Zellenarray (P1,..., PM) enthaltenen 2N Photozellen (Pij, Pij') ist.

13. Vorrichtung nach einem der vorangehenden Ansprüche, dadurch gekennzeichnet, daß die Verschiebungserzeugungseinrichtung mindestens ein piezoelektrisches Element (100, 102, 126, 128, 140, 142) aufweist.

14. Vorrichtung nach einem der Ansprüche 1 bis 12, dadurch gekennzeichnet, daß die Verschiebungserzeugungseinrichtung eine rechteckige Platte (100, 102, 126, 128, 140, 142) aus piezoelektrischem Material aufweist.

15. Vorrichtung nach Anspruch 14, gekennzeichnet durch eine aus einem elektrisch leitenden Material hergestellte Mutterplatte (104) mit einer Anzahl von Stiften (106), eine Trageinrichtung (108, 124, 146, 148) zur stabilen Halterung der piezoelektrischen Platte (100, 102, 126, 128, 140, 142) auf der Mutterplatte (104) unter Ermöglichung einer mechanischen Kopplung der piezoelektrischen Platte (100, 102, 126, 128, 140, 142) mit der Bildsensorvorrichtung (50) für eine Schwingung nach Maßgabe eines extern angelegten elektrischen Signals und flexible Verbindungsmittel (110, 112, 130, 150), die so verlaufen, daß sie bei einer Schwingung der piezoelektrischen Platte (100, 102, 126, 128, 140, 142) auf die Schwingung keine reelle Belastung ausüben, welche welche Dämpfung der Schwingung bewirkt (bewirken würde), wobei die Verbindungsmittel die Bildsensorvorrichtung (50) elektrisch mit den Stiften (106) verbinden.

16. Vorrichtung nach Anspruch 15, dadurch gekennzeichnet, daß die Verbindungsmittel einen Folienverbinder (110, 112, 130, 15) umfassen, dessen einer Hauptteil am dichtesten an die piezoelektrische Platte (100, 102, 126, 128, 140, 142) heranreicht.

17. Vorrichtung nach Anspruch 16, dadurch gekennzeichnet, daß die Antriebs- oder Treibereinrichtung zwei piezoelektrische Platten (140, 142) aufweist und die Trageinrichtung Tragplatten (146, 148) zum Tragen der piezoelektrischen Platten (140, 142) im wesentlichen parallel zueinander und im wesentlichen senkrecht zur Mutterplatte (104) sowie zur elastischen Halterung der piezoelektrischen Platten (140, 142) an beiden Enden derselben, in Längsrichtung gesehen, aufweist, wobei die piezoelektrischen Platten (140, 142) im gleichen Schwingungsmodus und in Richtung der Dicke der piezoelektrischen Platten (140, 142) selbst schwingen.

18. Vorrichtung nach Anspruch 17, dadurch gekennzeichnet, daß die piezoelektrischen Platten (140, 142) jeweils Seitenkanten aufweisen, an denen die Bildsensorvorrichtung (50) an (mit) der Rückseite befestigt ist.

19. Vorrichtung nach Anspruch 16, dadurch gekennzeichnet, daß ein Hauptabschnitt des Folienverbinders (110, 112, 130, 150) an der piezoelektrischen Platte angeklebt ist und entsprechend der Schwingung der piezoelektrischen Platten schwingt.

**Revendications**

1. Dispositif de détection d'une image de lumière incidente (16) comportant un dispositif de détection d'image à semi-conducteur (10, 50) qui détecte une image lumineuse compatible avec un système de télévision prédéterminé, dans lequel une image comporte plusieurs trames comprenant une première et une seconde trames, ledit dispositif de détection d'image (10, 50) comprenant un dispositif de détection (32) destiné à recevoir un rayonnement (16) représentant des informations d'image et à produire et à mémoriser des charges correspondant au rayonnement (16), ledit dispositif de détection (32) comportant au moins un réseau linéaire de cellules (P1,...PM) contenant un nombre prédéterminé de cellules (Pij, Pij') et un dispositif de transfert (C) disposé près dudit dispositif de détection (32) pour lire et transférer les charges emmagasinées dans ledit dispositif de détection (32), ledit dispositif de transfert (C) comportant au moins une section de transfert linéaire (C1,...CM) s'étendant le long dudit réseau linéaire de cellules (P1,...PM) et dans lequel un dispositif générateur de déplacement (12, 100, 102, 126, 128, 140, 142) est accouplé mécaniquement avec ledit dispositif de détection d'image (10, 50) pour faire osciller ledit dispositif de détection d'image (10, 50) de manière que le dispositif de détection d'image se déplace relativement dans un plan pratiquement perpendiculaire à la direction du rayonnement incident et chaque cellule étant située dans des positions de détection différentes pendant des périodes de trames différentes d'une période d'image du système de télévision de manière que les charges de signaux recueillies pendant la première période de trame soient lues simultanément dans ledit réseau de cellules (P1,...PM) vers ladite section de transfert (C1,...CM) avant que chacune desdites cellules soit située à la position suivante pour mémoriser des charges de signaux correspondant à une image de la seconde trame, de sorte que la résolution de l'image est améliorée.

2. Dispositif selon la revendication 1, caractérisé en ce que ladite section de transfert comporte des étages de transfert avec le même nombre que celui des cellules (Pij, Pij') que contient ledit réseau linéaire de cellules (P1,...PM).

3. Dispositif selon la revendication 1 ou la revendication 2, caractérisé en ce que ledit dispositif de détection (32) comporte une région de photo-dètection (32) formée sur une surface d'un substrat (51) qui fait partie dudit dispositif de détection d'image et dans lequel ledit dispositif générateur de déplacement (12, 100, 102, 126, 128, 140, 142) est accouplé mécaniquement avec ledit substrat (51).

4. Dispositif selon l'une quelconque des revendications 1 à 3, dans lequel ledit dispositif de détection (32) comporte un nombre (M) desdits réseaux linéaires de cellules (P1,...PM) disposés en parallèle entre eux et dont chacun comporte (2N) photos-cellules disposées linéairement, et ledit dispositif de transfert (C) comportant un nombre respectif (M) desdites sections de transfert linéaires (C1,...CM), chaque section de transfert étant disposée près d'un réseau de transfert respectif.

5. Dispositif selon la revendication 4, caractérisé en ce que, quand ledit système de télévision est le système NTSC, ledit dispositif générateur de déplacement (12, 100, 102, 126, 128, 140, 142) anime d'un mouvement alternatif ledit substrat (51) dudit dispositif de détection d'image (10, 50) dans ledit plan de manière à faire en sorte que chacun desdits réseaux de cellules (P1,...PM) s'arrête dans une première position de détection d'image pendant une première période de détection d'image de trame (ta) et que chacune desdites colonnes de cellules s'arrête dans une seconde position de détection d'image de trame pendant la seconde période de détection d'image de trame (tb).

6. Dispositif selon la revendication 5, caractérisé en ce que ledit dispositif de détection d'image (10, 50) comporte en outre un dispositif de porte de décalage de trame (34) formé sur ladite surface du substrat et s'étendant le long desdits (M) réseaux de cellules (P1,...PM) et lesdites (M) sections de transfert de charge (C1,...CM) et comprenant (M) sections de porte de décalage de trame connectées électriquement entre elles, et pour transférer simultanément vers lesdites sections de transfert de charge (C1,...CM) des charges de signaux emmagasinées dans lesdits réseaux de cellules (P1,...PM), pratiquement en synchronisme avec un mouvement rapide de chacun desdits réseaux de cellules (P1,...PM) entre ladite première et ladite seconde positions de détection d'image.

7. Dispositif selon la revendication 6, caractérisé en ce que chacune desdites sections de transfert de charge (C1,...CM) comporte le même nombre (2N) d'éléments de transfert que celui desdites photos-cellules que contient chacun desdits réseaux de cellules (P1,...PM) de manière que les charges de signaux emmagasinées dans lesdites photos-cellules de chacun desdits réseaux de cellules (P1,...PM) soient transférées auxdits éléments de transfert par ledit dispositif de porte à décalage de trame (34) respectivement.

8. Dispositif selon la revendication 4, caractérisé en ce que, quand le système de télévision est le système NTSC, ledit dispositif générateur de déplacement (12, 100, 102, 126, 128, 140, 142) fait osciller ledit substrat (51) dudit dispositif de détection d'image (10, 50) dans ledit plan de manière à pratiquement toujours le déplacer entre ladite première et ladite seconde positions d'une manière alternative, afin que lesdits réseaux de cellules (P1,...PM) effectuent l'opération de détection d'image pendant une période de trame (tf) tout en se déplaçant.

9. Dispositif selon la revendication 8, caractérisé en ce que ledit dispositif de détection d'image (10, 50) comporte en outre des sections de porte de décalage de trame (34) formées sur ladite surface du substrat et s'étendant le long desdits (M) réseaux de cellules (P1,...PM) et (M) sections de transfert de charge (C1,...CM), connectées électriquement entre elles, lesdites sections de porte de décalage de trame transférant simultanément les charges de signaux qui sont emmagasinées dans lesdits réseaux de cellules (P1,...PM) pratiquement au moment où chacun desdits réseaux de cellules (P1,...PM) atteint la position centrale entre ladite première et ladite seconde positions.

10. Dispositif selon la revendication 9, caractérisé en ce que chacune desdites sections de transfert de charge (C1,...CM) comporte le même nombre (2N) d'éléments de transfert que celui desdites photos-cellules que contient chacun desdits réseaux de cellules (P1,...PM) de manière que les charges de signaux emmagasinées dans lesdites photos-cellules de chacun desdits réseaux de cellules (P1,...PM) soient transférées vers lesdits éléments de transfert par ledit dispositif de porte de décalage de trame (34) respectivement.

11. Dispositif selon la revendication 7, caractérisé en ce que lesdits réseaux de cellules (P1,...PM) sont disposés de façon équidistante et dans lequel ledit dispositif générateur de déplacement (12, 100, 102, 126, 128, 140, 142) fait osciller ledit substrat (51) dans ledit plan et dans la direction pratiquement perpendiculaire à la direction dans laquelle s'étendent lesdits réseaux de cellules (P1,...PM) et d'une manière que la distance entre ladite première et ladite seconde positions de détection d'image soit de préférence la moitié de l'intervalle desdits réseaux de cellules (P1,...PM).

12. Dispositif selon la revendication 7, caractérisé en ce que lesdits réseaux de cellules (P1,...PM) sont disposés de façon équidistante et en ce que ledit dispositif de déviation (12, 100, 102, 126, 128, 140, 142) fait osciller ledit substrat (51) dans ledit plan dans une direction oblique par rapport à la direction dans laquelle s'étendent lesdits réseaux de cellules (P1,...PM) et de manière qu'une première composante de distance de la distance entre ladite première et ladite seconde positions de détection d'image, qui est dirigée perpendiculairement à ladite direction dans laquelle s'étendent les colonnes de cellules soit de préférence égale à la moitié de l'intervalle entre lesdits réseaux de cellules (P1,...PM) et qu'une seconde composante de distance dans la direction dans laquelle s'étendent lesdits réseaux de cellules (P1,...PM) soit de préférence égale à la moitié du pas desdites photos-cellules (Pij, Pij') parmi les (2N) que contient chacun desdits réseaux de cellules (P1,...PM).

13. Dispositif selon l'une quelconque des revendications précédentes, caractérisé en ce que ledit dispositif générateur de déplacement comporte au moins un élément piézo-électrique (100, 102, 126, 128, 140, 142).

14. Dispositif selon l'une quelconque des revendications 1 à 12, caractérisé en ce que ledit dispositif générateur de déplacement comporte une plaque piézo-électrique rectangulaire 100, 102, 126, 128, 140, 142) de matière piézo-électrique.

15. Dispositif selon la revendication 14, caractérisé en ce qu'il comporte en outre: une carte mère (104) faite d'une matière conductrice de l'électricité et avec plusieurs broches (106); un dispositif support (108, 124, 146, 148) destiné à supporter de façon stable ladite plaque piézo-électrique (100, 102, 126, 128, 140, 142) sur ladite carte mère (104) pour permettre que ladite plaque piézo-électrique (100, 102, 126, 128, 140, 142) accouplée mécaniquement avec ledit dispositif de détection d'image (50) puisse vibrer en fonction d'un signal électrique appliqué par l'extérieur; et un dispositif de connexion souple (110, 112, 130, 150) s'étendant de manière que lorsque ladite plaque piézo-électrique (100, 102, 126, 128, 140, 142) vibre, il n'applique pas la vibration à une charge réelle servant à atténuer la vibration, ledit dispositif de connexion reliant électriquement ledit dispositif de détection d'image (50) avec lesdites broches (106).

16. Dispositif selon la revendication 15, caractérisé en ce que ledit dispositif de connexion consiste en un connecteur pelliculaire (110, 112, 130, 150) avec une partie principale s'étendant à proximité de ladite plaque piézo-électrique (100, 102, 126, 128, 140, 142).

17. Dispositif selon la revendication 16, caractérisé en ce que ledit dispositif d'attaque comporte deux plaques piézo-électriques rectangulaires (140, 142) et ledit dispositif support comporte une plaque support (146, 148) pour supporter lesdites plaques piézo-électriques (140, 142) pratiquement parallèlement entre elles et pratiquement perpendiculairement à ladite carte mère (104), et pour supporter élastiquement lesdites plaques piézo-électriques (140, 142) aux deux extrémités desdites plaques piézo-électriques (140, 142) vues dans la direction longitudinale, lesdites plaques piézo-électriques (140, 142) vibrant dans le même mode de vibration et dans la direction de l'épaisseur desdites plaques piézo-électriques (140, 142) en elles-mêmes.

18. Dispositif selon la revendication 17, caractérisé en ce que lesdites plaques piézo-électriques (140, 142) comportent respectivement des bords latéraux sur lesquels est fixé ledit dispositif de détection d'image (50) à la surface arrière.

19. Dispositif selon la revendication 16, caractérisé en ce qu'une partie principale dudit connecteur pelliculaire (110, 112, 130, 150) est collée sur ladite plaque piézo-électrique et vibre en fonction de la vibration desdites plaques piézo-électriques.

0 083 240

# F I G. 1

SYNC. SIGNAL GENERATOR ~22

CCD DRIVER 20

DRIVE CIRCUIT 14

WAVE SHAPING CIRCUIT 26

1

0 083 240

FIG. 2

FIG. 3

$C_1$ $P_{11}$ 32 19 10 34

$P_{11}'$

$P_{12}$

$P_{12}'$

$C_M$

$P_{ij}$

$P_{ij}'$

$P_{1N}$

$P_{1N}'$

$P_1$

36 30

$P_{MN}$

$P_{MN}'$

$P_M$ S

$C_i$ 34 42

38

40 $P_{ij}'$

FIG. 4A

FIG. 4B

FIG. 5A

FIG. 5B

3

F I G. 6A

44    40   40c

F I G. 6B

F I G. 7A

F I G. 7B

F I G. 7C

48

# F I G. 8

# F I G. 9A

# F I G. 9B

# F I G. 9C

# F I G. 9D

F I G. 10A

F I G. 10B

F I G. 10C

F I G. 10D

F I G. 11A

44

40

40c

F I G. 11B

$t_F$

$t_a$    $t_b$    $t_c$    $t_d$

X

O                                                                    t

F I G. 11C

Y

O                                                                    t

F I G. 12

F I G. 13

18

$C_1$

$P_1$

$C_{11}$

$C_{11}'$

$C_{12}$

$C_{12}'$

50

F I G. 14

52

$C_1$

$P_1$

54

54

50

$C_{11}$

$C_{11}'$

$C_{12}$

$C_{12}'$

$A_y$

$A_x$

Y

X

- - - $(N-1)H_B$

→ $(N-1)H_A$

- - $NH_B$

→ $NH_A$

- - $(N+1)H_B$

→ $(N+1)H_A$

- - $(N+2)H_B$

→ $(N+2)H_A$

- - $(N+3)H_B$

→ $(N+3)H_A$

# F I G. 15A

# F I G. 15B

## F I G. 16

## F I G. 17

0 083 240

# FIG. 18A

# FIG. 18B

12

# FIG. 19A

# FIG. 19B

# FIG. 20

# FIG. 21